# EUROPEAN PATENT SPECIFICATION

(11) **EP 2 729 595 B1**
(45) Date of publication and mention of the grant of the patent: **01.02.2017**
(21) Application number: 12730564.7
(22) Date of filing: 29.06.2012
(51) Int. Cl.: C23C 22/52, H05K 3/38, C23F 1/18, H05K 3/28

(54) **METHOD FOR PROVIDING ORGANIC RESIST ADHESION TO A COPPER OR COPPER ALLOY SURFACE**
VERFAHREN ZUR BEREITSTELLUNG VON RESISTHAFTUNG AUF EINER KUPFER- ODER KUPFERLEGIERUNGSOBERFLÄCHE
PROCÉDÉ DE FOURNITURE D'ADHÉSION DE RÉSERVE SUR UN CUIVRE OU SURFACE D'ALLIAGE EN CUIVRE

(30) Priority: 07.07.2011 EP 11173040
(43) Date of publication of application: 14.05.2014
(73) Proprietor: Atotech Deutschland GmbH, 10553 Berlin (DE)
(72) Inventor: HÜLSMANN, Thomas, 14167 Berlin (DE); CLICQUE, Arno, 13435 Berlin (DE); TEWS, Dirk, 10318 Berlin (DE); KLOPPISCH, Mirko, 10245 Berlin (DE); LIONG, Andry, Guangzhou 5106660 (CN)
(86) International application number: PCT/EP2012/062733
(87) International publication number: WO 2013/004624

(56) References cited:
- WO-A1-02/04706
- WO-A1-2004/085706
- US-A- 3 434 889
- US-B1- 7 465 408

## Description

### Field of the Invention

The present invention relates to an adhesion promoting composition for the treatment of copper or copper alloys, a method of preparing a work piece having a copper or copper alloy surface for subsequent coating the copper or copper alloy surface with an organic resist material, using the adhesion composition, a method of forming copper structures on a circuit carrier substrate, using the adhesion composition, and a layer of copper oxide phase(s).

### Background of the Invention

At various stages in the process of manufacturing printed circuit boards and related goods, organic resist materials are coated to the copper surface of the printed circuit board material and must excellently adhere to the copper base. For example, in creating copper structures, *i.e.,* lines as well as bonding and soldering pads, a photo imaginable resist as organic resist material is used to define these structures. Furthermore, after these copper structures have been created, a solder mask as the organic resist material is applied to the structures in those regions which shall not be soldered. In both cases, the organic resist material is applied to the copper surface and must well adhere thereto both during the imaging process (exposing and developing) and during any subsequent process steps, like copper plating (in the course of copper structure generation) and soldering.

For this reason, pre-treatment of the copper or copper alloy surfaces is at all events to be performed in order to prepare the copper or copper alloy surface for a good organic resist material reception and hence adherence thereon. Etching solutions are used for this purpose, such as for example solutions containing an oxidant for copper, like hydrogen peroxide, sodium peroxodisulfate or sodium caroate. Etching has generally been considered indispensable because etching is used to roughen the copper or copper alloy surface. This is because roughening has been considered requisite to achieve good adherence of the organic resist material to the copper or copper alloy surface.

An example for such etching solutions is disclosed in WO 02/04706 A1. The etching solution described in this document is acidic and contains hydrogen peroxide, at least one five-membered nitrogen containing heterocyclic compound and additionally at least one microstructure modifying agent which is selected from the group comprising organic thiols, organic sulfides, organic disulfides and thioamides. The five-membered nitrogen containing heterocyclic compounds are tetrazoles and the derivatives thereof, such as 5-aminotetrazole and 5-phenyltetrazole. The microstructure modifying agents are for example selected from the group comprising L- and DL-cysteine, L-, DL- and D-cystine, 2-aminoethanethiol, mercaptoacetic acid, 3-mercaptopropionic acid, 2-mercaptoethanesulfonic acid, 3-mercaptopropanesulfonic acid, bis-(2-aminoethyl) disulfide, dithioacetic acid, 3,3'-dithiodipropionic acid, 4,4'-dithiodibutyric acid, 3,3'-dithio-bis-(propanesulfonic acid), thiodiacetic acid, 3,3'-thiodipropionic acid, thiourea, thiobenzamide and the salts thereof. Pre-treatment of the copper surfaces is performed to achieve good adherence of plating resists, etch resists, solder masks and other dielectric films thereon. Though little etching off of copper has been an object in this document in order to achieve low copper thickness variation due to the etching off, 10 % etching off of the copper relating to the overall thickness of the copper layer is still required to achieve good adherence. Furthermore, a variety of other etching solutions are mentioned in this document, which also contain hydrogen peroxide or another oxidant for copper.

Further, EP 0 890 660 A1 discloses a microetching agent for copper or copper alloys. This agent also contains hydrogen peroxide, further sulfuric acid and, in addition, at least one compound selected from the group consisting of tetrazoles and tetrazole derivatives. More specifically the tetrazole derivatives may be 1-methyltetrazole, 2-methyltetrazole, 5-aminotetrazole, 5-amino-1-methyltetrazole, 1-phenyltetrazole and 5-phenyltetrazole. This solution is used to roughen the copper surface of a printed circuit board by microetching and imparting deep, biting ruggedness in the copper surface of a depth of 1 to 5 µm.

A composition for microetching copper and copper alloys comprising an aromatic sulfonic acid and hydrogen peroxide is disclosed in WO 2004/085706 A1. The copper or copper alloy surface obtained is metallic and can be directly plated with a metal. Furthermore, the surfaces obtained have a bright appearance which is reflected by a RSAI value of only 3.6 % and a Rₘₐₓ value of < 40 nm. A resist material attached to such a surface shows an unacceptable high etching rate (Example 7).

The aforementioned etching solutions, however, are not suitable to be used in recent processes in which finest lines and other structures on the printed circuit boards are generated, like 10 µm lines (= desired width of circuitry lines) and 10 µm spaces (= desired distance between adjacent circuitry lines). In order to produce such ultra-fine circuitry, very thin copper is plated prior to forming these structures by etching. As copper in these processes is deposited by electroless plating, thickness thereof is about 1 µm only, for example. Meanwhile, using the above conventional microetchants, copper will be removed to a depth of at least 1 to 2 µm. For this reason, there will be the risk to totally remove the copper layer in at least part of the region on the surface due to the microetching step. This of course, will not be acceptable. For this reason, etching is considered detrimental to the consistency of the copper base.

### Objective of the Invention

It is a first objective of the present invention to provide a method for increasing the adhesion of organic resist materials on copper and copper alloy surfaces.

It is a second objective of the present invention to provide organic resist material patterned substrates for further plating of copper and copper alloys.

It is a third objective of the present invention to provide a method of forming finest copper structures on a circuit carrier substrate while allowing removal of at most 0.05 to 0.1 µm of copper or copper alloy and thereby forming copper oxide phase(s) to increase adhesion between the treated copper or copper alloy surface and an organic resist material.

### Summary of the Invention

These objectives are solved by the method of claim 1 for increasing the adhesion of organic resist materials on a copper or copper alloy surface.

The method according to the present invention leads to a high adhesion of organic resist materials on copper or copper alloy surfaces which remains when subjecting a substrate treated with the method to organic resist material developing chemistries, plating bath solutions, and soldering operations.

The very thin layer of copper oxide phase(s) obtainable by applying step b. to a substrate having a copper or copper alloy surface comprises copper and oxygen, has a thickness in the range of 5 to 300 nm, a RSAI value of > 50 % (compared to the underlying copper or copper alloy surface) and a Rₐ value of < 150 nm as determined by atomic force microscopy.

### Brief Description of the Figures

Figure 1 shows the resist line artwork used in Examples 1 and 2.
Figure 2 shows a micrograph of a resist material pattern according to the resist line artwork shown in Fig. 1 which was prepared with a method according to the prior art (Example 1).
Figure 3 shows a micrograph of a resist material pattern according to the resist line artwork shown in Fig. 1 which was prepared with the method according to the present invention (Example 2).
Figure 4 shows a dry film photo resist dot pattern obtained from Example 6.

### Detailed Description of the Invention

A substrate having a copper or copper alloy surface is contacted with an aqueous adhesion promoting solution comprising at least one organic acid and a peroxide compound and optionally one or more components selected form urea and derivatives thereof, water soluble polymers and salts of organic acids. Said aqueous adhesion promoting solution has a pH value in the range of 1.8 to 5 which is required to etch away as little copper or copper alloy from the substrate as possible and at the same time provide a sufficient adhesion to organic resist materials.

Copper and copper alloy surfaces which can be treated with method according to the present invention comprise copper and copper alloy clad laminate substrates (CCI), copper and copper alloy surfaces which were deposited with a direct current electrolytic copper process (DC) and copper or copper alloys deposited by electroless plating.

Next, an organic resist material is attached to the pre-treated copper or copper alloy surface. The organic resist material can be for example a photo imaginable resist which is later on removed or a solder mask which stays attached to the copper or copper alloy surface.

Photo imaginable resists are usually applied as a dry film or a liquid film. The dry film is a common photo imaginable resist consisting of a cover or support sheet, a photo imaginable layer, and a protective layer, as provided for example by DuPont and Hitachi. Liquid photo resist are applied directly onto the copper layer by, *e.g.,* roller coating, curtain coating, without protective layers (e.g., Huntsman, Dow, Atotech).

These methods are well-known in the art and are for example described in Coombs, Printed Circuits Handbook 5th Edition, Chapter 26.

Solder masks are organic resist materials that provide a permanent protective coating for the copper or copper alloy surface of a printed circuit board, IC substrate and the like.

Other organic resist materials according to the present invention are plating resists which are patterned using ablation instead of a photo structuring method. Patterns in such plating resists can be generated by e.g. laser ablation. Such materials are also known as laser imaginable resists.

In case the organic resist material needs to be removed from the copper or copper alloy surface later on, the treatment according to the present invention allows using conventional resist stripping compositions for this task.

The at least one organic acid in the aqueous adhesion promoting solution is selected from the group consisting of carboxylic acids, hydroxycarboxylic acids, aminocarboxylic acids and sulfonic acids.

Said organic acid can be partially substituted by a salt of an organic acid. Suitable cations for salts of an organic acid are selected from the group comprising ammonium, lithium, sodium and potassium.

More preferably, the at least one organic acid is selected from the group consisting of carboxylic acids, hydroxycarboxylic acids and aminocarboxylic acids. Most preferably, the at least one organic acid is selected from the group consisting of carboxylic acids and hydroxycarboxylic acids.

Particularly suitable carboxylic acids are alkane carboxylic acids such as formic acid, acetic acid, propionic acid and butyric acid.

Particularly suitable aminocarboxylic acids are selected from the group consisting of 6-aminohexanoic acid, glycine and cysteine.

Particularly suitable sulfonic acids are selected from the group consisting of alkane sulfonic acids and aromatic sulfonic acids such as methanesulfonic acid, phenol sulfonic acid and toluene sulfonic acid.

The concentration of the at least one organic acid is adjusted in order to obtain a pH value for the adhesion promoting composition in the range of 1.8 to 5 and more preferably from 3 to 4.

The concentration of the at least one organic acid or in case a mixture of organic acids is used the overall concentration of all organic acids preferably ranges from 0.005 to 0.04 mol/l.

The concentration of the at least one organic acid or in case a mixture of organic acids is used the overall concentration of all organic acids ranges from 0.005 to 0.008 mol/l in case the at least one organic acid is a sulfonic acid (or mixtures of organic acids comprising a sulfonic acid) which is due to the lower pkₛ value of sulfonic acids compared to e.g. alkane carboxylic acids such as acetic acid.

The pH value of the adhesion promoting solution depends on the type of organic acid employed and the respective concentration and is very important because of several reasons:
1. in case the pH value is lower than 1.8 the copper or copper alloy surface is micro-etched during the treatment. This is not acceptable for manufacturing the desired fine line structures because too much of the thin copper or copper alloy layer serving as the surface of the substrate is etched away.
2. in case the pH value is above 5 no adhesion promoting effect is obtained by such a treatment.

The adhesion promoting solution further contains a peroxide compound which is selected from the group consisting of hydrogen peroxide, inorganic peroxide salts, organic peroxide compounds and mixtures thereof. The most preferred peroxide compound is hydrogen peroxide.

The concentration of the peroxide compound or mixture of more than one peroxide compounds ranges from 0.01 to 2.5 mol/l, more preferably from 0.1 to 1.5 mol/l.

Further optional components of the adhesion promoting solution are selected from the group consisting of urea and derivatives thereof and water soluble polymers.

The concentration of optional urea or derivative thereof ranges from 0.1 to 50 g/l, more preferably from 1 to 5 g/l.

The optional water-soluble polymer is selected from the group consisting of polyethylene glycol, polypropylene glycol and co-polymers of the aforementioned.

The concentration of the optional water soluble polymer ranges from 0.01 to 100 g/l, more preferably from 0.1 to 10 g/l.

The aqueous adhesion promoting solution is free or essentially free of N-heterocyclic compounds such as azole compounds, pyridine and N-methyl pyrrolidone. Examples for azole compounds comprise triazoles, tetraazoles, benzotriazole and derivatives of the aforementioned. Such N-heterocyclic compounds avoid the formation of copper oxide phase(s) on top of the copper or copper alloy surface. Accordingly, a metallic surface is obtained in the presence of such a N-hetrocyclic compound in an aqueous solution comprising an organic acid and a peroxide compound. The adhesion between such a metallic surface and an organic resist material is not sufficient.

Preferably, the aqueous adhesion promoting solution is free or essentially free of inorganic acids such as sulfuric acid, hydrochloric acid and phosphoric acid.

The substrate having a surface of copper or a copper alloy is contacted with the aqueous adhesion promoting solution by either dipping or spraying. The preferred mode of contacting is spraying. The solution is held at a temperature in the range of 20 to 50 °C. The contact time is at least 5 s. The maximum contact time is only limited by economic reasons.

The methods described herein may be performed in a conventional dip-tank technique (vertical processing) or in a conveyorised machine (horizontal processing).

The samples are preferably treated by spraying the adhesion promoting solution according to the invention onto the samples. The solution can be sprayed in a vertical mode or horizontal mode, depending on the equipment desired. Alternatively, the samples can be immersed into the adhesion promoting composition. To achieve the same roughness values compared to spraying, the solution may needs to be penetrated by oxygen, e.g., by bubbling air through it.

When contacting a substrate having a copper or copper alloy surface with such a solution a very thin layer of copper oxide phase(s) is formed without considerably etching the copper or copper alloy surface. This is important as the method according to the present invention is especially useful in case the thickness of the copper or copper alloy layer to be treated is below 5 µm. The copper oxide phase(s) generated by the method according to the present invention show a high adhesion to the underlying copper or copper alloy surface.

The layer of copper oxide phase(s) obtained by the method according to the present invention comprises the chemical elements copper and oxygen, optionally also hydrogen contributing to hydroxy moieties and/or embedded water molecules. Preferably, the layer of copper oxide phase(s) has a thickness in the range of 5 to 300 nm, more preferably of 10 to 60 nm.

The characteristic bronze colour of the copper oxide phase(s) obtained in step b. of the method according to the present invention can be used for visual inspection during production of printed circuit boards, IC substrates and the like. The colour provides a simple indicator whether the treatment of the copper or copper alloy substrate surface is sufficient or not.

The surface topography of said layer of copper oxide phase(s) as determined by atomic force microscopy (AFM) is considerably altered compared to the underlying copper or copper alloy surface. This is expressed by the RSAI value of preferably > 50 % characteristic for the layer of copper oxide phase(s). The RSAI value can be determined with an atomic force microscope by scanning both the untreated copper or copper alloy surface and the copper or copper alloy surface after treatment with the method according to the present invention. RSAI: Relative Surface Area Increase; a value of 50 % means that the surface area of a coating is increased by 50 % in comparison to the underlying substrate surface.

At the same time, the average surface roughness Rₐ is < 150 nm (also determined by AFM) indicating that less copper of the underlying substrate is etched compared to adhesion promoting methods known in the art. Moreover, said combination of favourable RSAI and Rₐ values is independent from the microstructure (grain size) of the copper or copper alloy of the underlying substrate.

The layers of different oxide phase(s) obtainable by adhesion promoting methods known in the art have a surface topography which strongly depends on the microstructure (grain size) of the underlying copper or copper alloy surface. This is reflected by a high RSAI value and at the same time by a high Rₐ value of the copper oxide phase(s) layer formed during such adhesion promoting methods.

Accordingly, the amount of copper or copper alloy removed during formation of copper oxide phase(s) is too high for the desired application.

It is assumed that these copper oxide phase(s) provide the adhesion between a copper or copper alloy surface and the attached organic resist material.

Optionally, the substrate surface is rinsed between steps b. and c.

In case a temporary resist such as a dry film resist which is later on removed from the copper or copper alloy surface the copper oxide phase(s) can be easily removed by contacting the substrate with diluted acid such as diluted sulfuric acid or an oxidizing agent such as hydrogen peroxide.

The following non-limiting examples further illustrate the present invention.

### Examples

The dry film photo resist adhesion on copper surfaces was determined after pre-treatment of the copper surface.

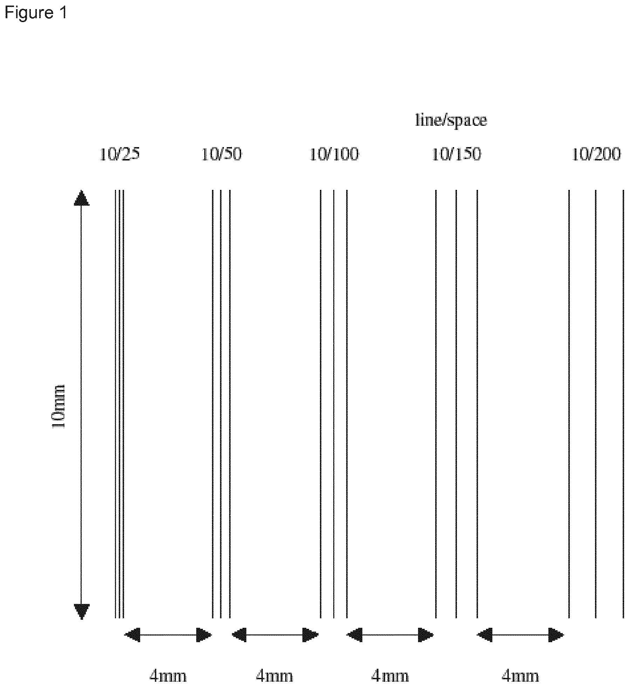

Test panels having a surface of DC copper were used throughout all tests. The panels were first cleaned with an acidic cleaner (AcidClean^{®} UC, a product of Atotech Deutschland GmbH) and then contacted with different aqueous pre-treatment compositions by spraying the pre-treatment compositions onto the test panels. Next, the test panels were rinsed with water, dried and a dry film photo resist was laminated onto the pre-treated surface of the test panels and patterned using standard methods. Two kinds of dry film photo resist patterns were tested:
a) resist lines having a line width of 10 µm and line spaces ranging from 25 to 200 µm The resist line artwork used throughout Examples 1 and 2 is shown in Fig. 1. Here, resist lines having a width of 10 µm, line spaces ranging from 25 µm (left side of Fig. 1) to 200 µm (right side of Fig. 1) and a length of 100 µm are desired, and
b) a dot pattern comprising resist dots having dot sizes of 15 to 30 µm.

The adhesion of the dry film photo resist was measured by optical microscope after developing (patterning) the dry film photo resists in an aqueous solution of 1 wt.-% sodium carbonate.

In case of the resist dot pattern (Examples 3 to 6) the remaining resist dots were counted and rated in terms of percentage of dots remaining on the copper surface after resist development in respect to the number of expected dots (= 100 %). I.e., a high percentage of remaining photo resist dots indicates a good adhesion and a low percentage of remaining photo resist dots indicates an insufficient adhesion.

Furthermore, the surface topography of the copper oxide phase(s) obtained was determined by atomic force microscopy (AFM). An area of 10 µm x 10 µm was scanned three times in the tapping mode with a Digital Instruments NanoScope III AFM at a scan rate of 0.5003 Hz to obtain the RSAI and Rₐ values given in the Examples.

### Example 1 (comparative)

A test panel was contacted with a 5 wt-% sulfuric acid solution at a temperature of 35 °C by spraying.

The RSAI value obtained after this treatment is 10 % and the corresponding Rₐ value is 100 nm.

Next, the substrate was rinsed with water and dried. A dry film photo resist (Hitachi RY 3619) was laminated onto the pre-treated copper surface and patterned.

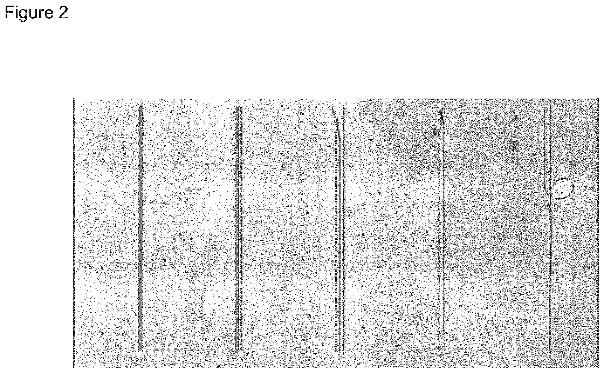

The resulting dry film photo resist pattern is shown in Fig. 2. The dry film photo resist lines are partly delaminated from the copper surface indicating an insufficient adhesion.

### Example 2

A test panel was contacted with an aqueous solution consisting of 1 g/l formic acid (0.02 mol/l) and 35 ml/l of hydrogen peroxide (35 wt.-% stock solution) having a pH value of 2.6 by spraying. The temperature of the aqueous solution was 35 °C and the contact time 60 s.

The RSAI value is 110 % and the corresponding Rₐ value is 140 nm.

Next, the substrate was rinsed with water and dried. A dry film photo resist (Hitachi RY 3619) was laminated onto the pre-treated copper surface and patterned.

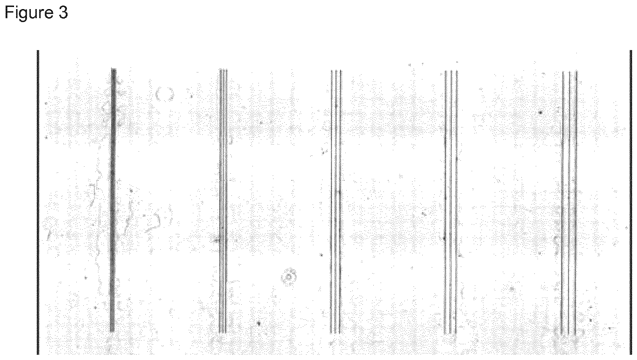

The dry film photo resist lines obtained after patterning are shown in Fig. 3. The adhesion of the dry film photo resist on the copper surface is high, i.e., no delamination of the photo resist occurred.

### Example 3 (comparative)

The test panels having a surface of DC copper were cleaned as described above and then contacted with diluted (5 wt.-%) sulfuric acid by spraying.

Next, the substrate was rinsed with water, dried and a dry film photo resist (Hitachi RY 3619) was laminated onto the DC copper surface and patterned in order to obtain a photo resist pattern having dots of 18 µm diameter.

The test panels were inspected by optical microscopy after patterning. The number of photo resist dots was counted. The result is expressed in percentage of photo resist dots observed on basis of the expected number of photoresist dots, i.e. 100 % resembles to the full photo resist dot pattern expected on the copper surface.

Only 8.2 % out of 100 % of expected photo resist dots were observed when using diluted sulfuric acid as pre-treatment. This is considered not acceptable for manufacturing purpose.

### Example 4 (comparative)

The test panels having a surface of DC copper were cleaned as described above and then contacted with an aqueous solution consisting of diluted (5 wt.-%) sulfuric acid and 35 ml/l of hydrogen peroxide (35 wt.-% solution) by spraying. Next, the substrate was rinsed with water and dried.

The RSAI value is 10 % and the corresponding Rₐ value is 100 nm.

A dry film photo resist (Hitachi RY 3619) was then laminated onto the DC copper surface and patterned in order to obtain a photo resist pattern having dots of 18 µm diameter.

The test panels were inspected as described in Example 3.

None of the expected photo resist dots were observed. This is considered not acceptable for manufacturing purpose.

### Example 5 (comparative)

The test panels having a surface of DC copper were cleaned as described above and then contacted with an aqueous solution consisting of 1 g/l formic acid and 35 ml/l of hydrogen peroxide (35 wt.-% solution) and having a pH of 2.6 by spraying (see Example 2). Next, the oxide layer formed on the copper surface was removed by immersing the substrate in diluted sulfuric acid and then rinsed with water and dried.

A dry film photo resist (Hitachi RY 3619) was then laminated onto the DC copper surface and patterned in order to obtain a photo resist pattern having dots of 18 µm diameter.

The test panels were inspected as described in Example 3.

Only 0.9 % out of 100 % of expected photo resist dots were observed. This is considered not acceptable for manufacturing purpose.

### Example 6

The test panels having a surface of DC copper were cleaned as described above and then contacted with an aqueous solution consisting of 1 g/l formic acid and 35 ml/l of hydrogen peroxide (35 wt.-% solution) and having a pH of 2.6 by spraying. Next, the substrate was rinsed with water, dried and a dry film photo resist (Hitachi RY 3619) was laminated onto the DC copper surface and patterned in order to obtain a photo resist pattern having dots of 18 µm diameter.

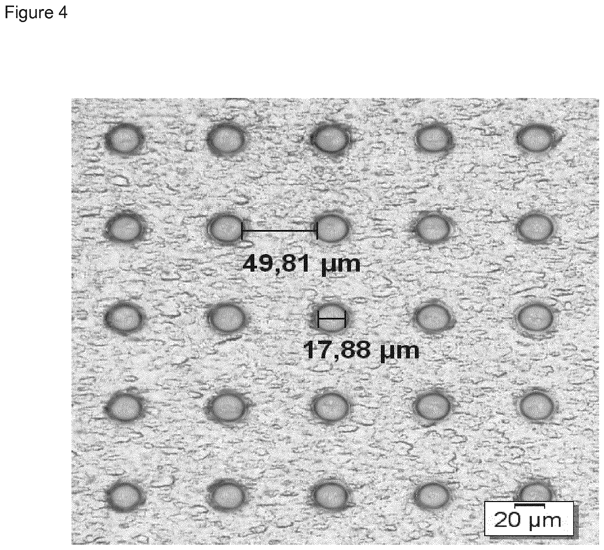

The test panels were inspected as described in Example 3. A portion of the substrate surface having photo resist dots obtained from Example 6 is shown in Fig. 4.

86.6 % out of 100 % of expected photo resist dots were observed on the copper surface. This is considered very good for manufacturing purpose.

### Example 7 (comparative)

The test panels having a surface of DC copper were cleaned as described above and then contacted with an aqueous solution consisting of 25 g/l toluene sulfonic acid (0.145 mol/l) and 100 g/l of a 35 wt.-% solution of hydrogen peroxide (Example 1 b in WO 2004/085706 A1). The pH value of this aqueous solution was 1.37. The contact time was 1 min and the temperature of the solution was 35 °C.

A shiny copper surface was obtained and 1.4 µm of the DC copper layer were etched away during treatment with this aqueous solution (as determined from a cross sectioned sample by scanning electron microscope). Such a high etch rate is not acceptable in the manufacture of components having a fine line circuitry. Accordingly, such an aqueous solution is not applicable for providing sufficient adhesion between a thin copper layer and an organic resist material.

## Claims

1. Method for increasing the adhesion of organic resist materials on a copper or copper alloy surface, the method comprising the steps of
a. providing a substrate having a copper or copper alloy surface,
b. contacting said surface with an aqueous adhesion promoting solution comprising
i. at least one organic acid selected from the group consisting of carboxylic acids, hydroxycarboxylic acids, aminocarboxylic acids and sulfonic acids and
ii. a peroxide compound
wherein the concentration of the at least one organic acid or in case of more than one organic acid the overall concentration of all organic acids ranges from 0.005 to 0.04 mol/l,
wherein the concentration of the sulfonic acid ranges from 0.005 to 0.008 mol/l,
wherein the pH value of the aqueous adhesion promoting solution ranges from 1.8 to 5
and thereby forming a layer of copper oxide phase(s) on top of the copper or copper alloy surface
and
c. attaching an organic resist material onto the layer of said copper oxide phase(s).

2. Method according to claim 1 wherein the carboxylic acid is an alkane carboxylic acid.

3. Method according to claim 1 wherein the aminocarboxylic acid is selected from the group consisting of 6-aminohexanoic acid, glycine and cysteine.

4. Method according according to claim 1 wherein the sulfonic acid is selected from the group consisting of alkane sulfonic acids and aromatic sulfonic acids.

5. Method according to any of the foregoing claims wherein the concentration of the peroxide compound in the aqueous adhesion promoting solution ranges from 0.01 to 2.5 mol/l.

6. Method according to any of the foregoing claims wherein the peroxide compound is hydrogen peroxide.

7. Method according to any of the foregoing claims wherein the aqueous adhesion promoting solution further comprises a water soluble polymer selected from the group consisting of polyethylene glycol, polypropylene glycol and co-polymers of the aforementioned.

8. Method according to any of the foregoing claims wherein the aqueous adhesion promoting solution further comprises urea or a derivative thereof.

9. Method according to any of the foregoing claims wherein the aqueous adhesion promoting solution is essentially free of a N-heterocyclic compound.

10. Method according to any of the foregoing claims wherein the layer of copper oxide phase(s) has a thickness of 5 to 300 nm.

11. Method according to any of the foregoing claims wherein the layer of copper oxide phase(s) has a RSAI value of > 50 % compared to the underlying copper or copper alloy layer and a Rₐ value of < 150 nm as determined by atomic force microscopy.

12. Method according to any of the foregoing claims wherein the aqueous adhesion promoting solution in step b. has a temperature of 20 to 50 °C.

13. Method according to any of the foregoing claims wherein the substrate is contacted with the aqueous adhesion promoting solution in step b. for at least 5 s.

14. Method according to any of the foregoing claims wherein the substrate is contacted with the aqueous adhesion promoting solution by spraying.

## Patentansprüche

1. Verfahren zur Erhöhung der Haftung von organischen Resistmaterialien auf einer Kupfer- oder Kupferlegierungsoberfläche, wobei das Verfahren folgende Schritte umfasst:
a. Bereitstellen eines Substrats mit einer Kupfer- oder Kupferlegierungsoberfläche,
b. Inberührungbringen der Oberfläche mit einer wässrigen Haftvermittlungslösung, umfassend
i. mindestens eine organische Säure aus der Gruppe bestehend aus Carbonsäuren, Hydroxycarbonsäuren, Aminocarbonsäuren und Sulfonsäuren und
ii. eine Peroxidverbindung,
wobei die Konzentration der mindestens einen organischen Säure oder im Fall von mehr als einer organischen Säure die Gesamtkonzentration aller organischen Säuren im Bereich von 0,005 bis 0,04 mol/l liegt,
wobei die Konzentration der Sulfonsäure im Bereich von 0,005 bis 0,008 mol/l liegt,
wobei der pH-Wert der wässrigen Haftvermittlungslösung im Bereich von 1,8 bis 5 liegt, wodurch auf der Kupfer- oder Kupferlegierungsoberfläche eine Schicht aus Kupferoxidphase(n) gebildet wird,
und
c. Auftragen eines organischen Resistmaterials auf die Schicht aus der Kupferoxidphase bzw. den Kupferoxidphasen.

2. Verfahren nach Anspruch 1, bei dem es sich bei der Carbonsäure um eine Alkancarbonsäure handelt.

3. Verfahren nach Anspruch 1, bei dem die Aminocarbonsäure aus der Gruppe bestehend aus 6-Aminohexansäure, Glycin und Cystein ausgewählt wird.

4. Verfahren nach Anspruch 1, bei dem die Sulfonsäure aus der Gruppe bestehend aus Alkansulfonsäuren und aromatischen Sulfonsäuren ausgewählt wird.

5. Verfahren nach einem der vorhergehenden Ansprüche, bei dem die Konzentration der Peroxidverbindung in der wässrigen Haftvermittlungslösung im Bereich von 0,01 bis 2,5 mol/l liegt.

6. Verfahren nach einem der vorhergehenden Ansprüche, bei dem es sich bei der Peroxidverbindung um Wasserstoffperoxid handelt.

7. Verfahren nach einem der vorhergehenden Ansprüche, bei dem die wässrige Haftvermittlungslösung ferner ein wasserlösliches Polymer aus der Gruppe bestehend aus Polyethylenglykol, Polypropylenglykol und Copolymeren davon umfasst.

8. Verfahren nach einem der vorhergehenden Ansprüche, bei dem die wässrige Haftvermittlungslösung ferner Harnstoff oder ein Derivat davon umfasst.

9. Verfahren nach einem der vorhergehenden Ansprüche, bei dem die wässrige Haftvermittlungslösung im Wesentlichen frei von einer N-heterocyclischen Verbindung ist.

10. Verfahren nach einem der vorhergehenden Ansprüche, bei dem die Schicht aus Kupferoxidphase(n) eine Dicke von 5 bis 300 nm aufweist.

11. Verfahren nach einem der vorhergehenden Ansprüche, bei dem die Schicht aus Kupferoxidphase (n) einen RSAI-Wert von > 50% im Vergleich zu der darunterliegenden Kupfer- oder Kupferlegierungsschicht und einen Rₐ-Wert von < 150 nm gemäß Bestimmung mittels Atomkraftmikroskopie aufweist.

12. Verfahren nach einem der vorhergehenden Ansprüche, bei dem die wässrige Haftvermittlungslösung in Schritt b. eine Temperatur von 20 bis 50°C aufweist.

13. Verfahren nach einem der vorhergehenden Ansprüche, bei dem das Substrat mit der wässrigen Haftvermittlungslösung in Schritt b. über einen Zeitraum von mindestens 5 s in Berührung gebracht wird.

14. Verfahren nach einem der vorhergehenden Ansprüche, bei dem das Substrat mit der wässrigen Haftvermittlungslösung durch Sprühen in Berührung gebracht wird.

## Revendications

1. Procédé d'augmentation de l'adhérence de matériaux de réserve organiques sur une surface de cuivre ou d'alliage de cuivre, le procédé comprenant les étapes de
a. fournir un substrat ayant une surface de cuivre ou d'alliage de cuivre,
b. mettre ladite surface en contact avec une solution aqueuse favorisant l'adhérence comprenant
i. au moins un acide organique choisi dans le groupe constitué par les acides carboxyliques, les acides hydroxycarboxyliques, les acides aminocarboxyliques et les acides sulfoniques et
ii. un composé peroxydique,
la concentration de l'au moins un acide organique ou dans le cas de plus d'un acide organique la concentration globale de tous les acides organiques allant de 0,005 à 0,04 mol/l,
la concentration de l'acide sulfonique allant de 0,005 à 0,008 mol/l,
la valeur de pH de la solution aqueuse favorisant l'adhérence allant de 1,8 à 5,
et former ainsi une couche de phase(s) d'oxyde de cuivre au-dessus de la surface de cuivre ou d'alliage de cuivre
et
c. fixer un matériau de réserve organique sur la couche de ladite/desdites phase(s) d'oxyde de cuivre.

2. Procédé selon la revendication 1 dans lequel l'acide carboxylique est un acide alcanecarboxylique.

3. Procédé selon la revendication 1 dans lequel l'acide aminocarboxylique est choisi dans le groupe constitué par l'acide 6-aminohexanoïque, la glycine et la cystéine.

4. Procédé selon la revendication 1 dans lequel l'acide sulfonique est choisi dans le groupe constitué par les acides alcanesulfoniques et les acides sulfoniques aromatiques.

5. Procédé selon l'une quelconque des revendications précédentes dans lequel la concentration du composé peroxydique dans la solution aqueuse favorisant l'adhérence va de 0,01 à 2,5 mol/l.

6. Procédé selon l'une quelconque des revendications précédentes dans lequel le composé peroxydique est le peroxyde d'hydrogène.

7. Procédé selon l'une quelconque des revendications précédentes dans lequel la solution aqueuse favorisant l'adhérence comprend en outre un polymère hydrosoluble choisi dans le groupe constitué par le polyéthylène glycol, le polypropylène glycol et les copolymères de ceux-ci.

8. Procédé selon l'une quelconque des revendications précédentes dans lequel la solution aqueuse favorisant l'adhérence comprend en outre de l'urée ou un dérivé de celle-ci.

9. Procédé selon l'une quelconque des revendications précédentes dans lequel la solution aqueuse favorisant l'adhérence est essentiellement dépourvue d'un composé N-hétérocyclique.

10. Procédé selon l'une quelconque des revendications précédentes dans lequel la couche de phase(s) d'oxyde de cuivre a une épaisseur de 5 à 300 nm.

11. Procédé selon l'une quelconque des revendications précédentes dans lequel la couche de phase(s) d'oxyde de cuivre a une valeur RSAI > 50 % par rapport à la couche de cuivre ou d'alliage de cuivre sous-jacente et une valeur Rₐ < 150 nm telle que déterminée par microscopie à force atomique.

12. Procédé selon l'une quelconque des revendications précédentes dans lequel la solution aqueuse favorisant l'adhérence à l'étape b. a une température de 20 à 50 °C.

13. Procédé selon l'une quelconque des revendications précédentes dans lequel le substrat est mis en contact avec la solution aqueuse favorisant l'adhérence à l'étape b. pendant au moins 5 s.

14. Procédé selon l'une quelconque des revendications précédentes dans lequel le substrat est mis en contact avec la solution aqueuse favorisant l'adhérence par pulvérisation.
